Europäisches Patentamt

European Patent Office

Office européen des brevets

(11) Publication number: **0 135 301**
**B1**

(12) **EUROPEAN PATENT SPECIFICATION**

(45) Date of publication of patent specification: **02.03.88**

(21) Application number: **84304965.1**

(22) Date of filing: **20.07.84**

(51) Int. Cl.⁴: **H 03 D 3/00**

(54) Demodulation circuit from FM signals and demodulation system therefor.

(30) Priority: **22.07.83 JP 134982/83**
**22.07.83 JP 134983/83**

(43) Date of publication of application:
**27.03.85 Bulletin 85/13**

(45) Publication of the grant of the patent:
**02.03.88 Bulletin 88/09**

(84) Designated Contracting States:
**DE FR GB**

(56) References cited:
**EP-A-0 048 661**
**EP-A-0 064 819**
**US-A-4 101 837**

(73) Proprietor: **SHARP KABUSHIKI KAISHA**
**22-22 Nagaike-cho Abeno-ku**
**Osaka 545 (JP)**

(72) Inventor: **Ohta, Tomozo**
**6-3 1-chome, ShikanodaiNishi**
**Ikoma-shi Nara-ken (JP)**

(74) Representative: **Wright, Peter David John et al**
**R.G.C. Jenkins & Co. 26 Caxton Street**
**London SW1H 0RJ (GB)**

Courier Press, Leamington Spa, England.

## Description

This invention concerns a highly sensitive FM signal demodulation circuit for improving the threshold characteristic at a low reception C/N ratio (carrier power to noise power ratio) and improving the noise characteristic of demodulated signals such as broad band TV-FM (television frequency modulated) signal waves, and an FM signal demodulation method performed by such a circuit.

Heretofore, a frequency demodulation system using a frequency discriminator comprising an LC circuit or delay line has often been employed as the most convenient way for demodulating frequency-modulated signals. In this case, the S/N ratio (signal to noise ratio) of FM demodulated input signals is expressed as:

$$S/N = C/N.F1 \quad (F1: \text{ Constant})$$

and thus the S/N ratio is in proportion to the C/N ratio. While on the other hand, the C/N ratio is determined by the band width B of a band pass filter used for restricting the band width B of noises and signals upon demodulation. Usually, the band width is represented according to the Curson rule as:

$$B \approx 2 \ (\Delta f + fh)$$

where $\Delta f$ is the frequency deviation width of the FM modulated waves and fh is the highest modulated frequency in the modulated waves.

The relationship between the CN and the SN ratios changes linearly until the CN ratio is at a level of about 10 db but, if the CN ratio decreases further, the S/N ratio is rapidly worsened by the impulse noises inherent in the FM demodulation. This level is referred to as the threshold.

Generally, in the communication for transmitting TV signals, for example, satellite communication, FM modulation have often been used for the transmission of signals. In the satellite communication lines, the power margin upon reception is reduced as far as possible in view of the limit for the transmission power of a satellite, the stability in the satellite communication paths, the stability in the transmission power of the satellite and the economy of the ground receiving facilities, and the working point is often set near the reception threshold. Therefore when the received input is sometimes decreased due to the fluctuations in various operating conditions, the receiving level falls below the threshold, and the quality of the demodulated images on a TV monitor is significantly disturbed by the impulse noises inherent in FM transmission and further, it may even lead to a state where modulated images cannot be obtained.

Accordingly in the reception of satellite communication, it is very important to reduce the impulse noises by a simple way so as to improve the quality of the demodulated TV images, while avoiding increasing the cost of the receiving facilities. Particularly in a satellite-receiving device such as for the reception from a broadcasting satellite, it is extremely important to obtain a method of improving the threshold characteristic using a simple circuit.

EP—A—0064819 discloses an FM demodulation system in which prior to being passed through a frequency discriminator, an FM signal is subjected to variable band pass filtering, the band width of the band pass filter employed for this purpose being controlled in accordance with the detected signal level of the FM signal, and more particularly with the total power of the FM signal or the carrier signal to noise ratio. The band width is controlled to be narrow when the signal level is close to or lower than the demodulating threshold and wide when the signal is high. The purpose of these measures is to improve the threshold characteristics.

Another system for improving the threshold characteristics employs FM feedback and it is this type of circuit to which the present invention relates.

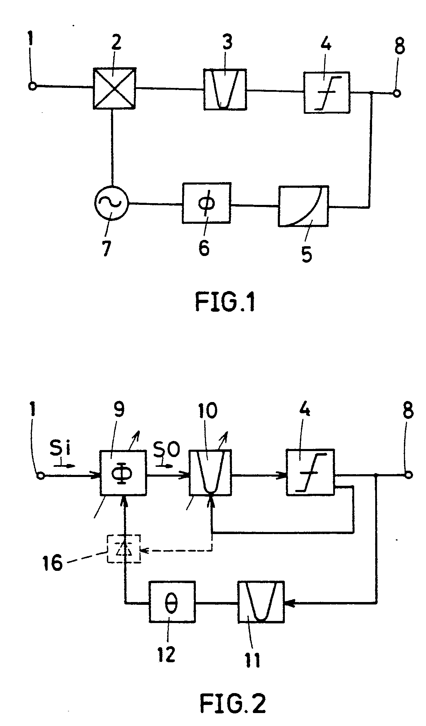

Figure 1 shows the construction of a known feedback demodulation system.

FM signals are inputted to an input terminal 1, frequency modulated in a frequency converter 2, and supplied by way of a band pass filter 3 to a frequency discriminator 4 containing an amplifier and a limiter. FM demodulated wave signals are derived from an output terminal 8. The output from the frequency discriminator 4 is supplied by way of a low pass filter 5 to a phase shifter 6 including a feed back amplifier. The output from the phase shifter 6 is supplied to a variable frequency oscillator 7 and the output therefrom is supplied to the frequency converter.

The FM signals from the input terminal 1 are converted in the frequency converter 2, passed through the band pass filter three and then frequency detected by the discriminator 4. A portion of the base band signals demodulated in the discriminator 4 is supplied through the low pass filter 5, and the phase shifter 6 including an amplifier or the like and then supplied to the variable frequency oscillator 7, to control the oscillation frequency.

The base band feedback circuit comprising the low pass filter 5, the phase shifter 6 and the like, when opened, has a similar circuit structure to that of the ordinary frequency demodulation system only using the discriminator 4, wherein the band width B of the band pass filter 3 requires a Curson band width determined by the highest modulated frequency and the frequency deviation of the FM signals as described above.

In the FM feedback demodulation circuit illustrated in Figure 1, if the oscillation frequency from the variable frequency oscillator 7 is controlled in accordance with instantaneous frequency changes in the FM signals inputted from the input terminal 1 and if it is exerted in the direction of compressing the frequency deviation in the output signals from the frequency converter 2 as compared with that of the input signals, it is possible to narrow the Curson band width required for demodulation, that is, the band width of the band pass filter 3. That is, since the C/N ratio of the FM signals applied to the discriminator 4 is improved as compared with the case of not applying the feedback, the threshold characteristic can be improved.

As is well-known, the television (colour video) signals relevant to this invention comprise luminant signals and a colour sub carrier component and the base band signals thereof are very broad band signals up to 4.2 MHz in the NTSC system. Further, the magnitude of the frequency spectrum for the base band signals are significantly varied in the video signals depending on the kind of images (object) to be transmitted. Particularly, the amplitude of the colour sub carrier component is changed greatly depending on the density (degree of saturation) of colours of the images. Because of such an inherent nature of the TV signals, several difficulties have arisen upon FM demodulation in the known system shown in Figure 1.

Due to such a broad band characteristic of the base band signals, it is difficult to supply the demodulated signal component from the discriminator 4 to the variable frequency oscillator 7 by way of a feedback circuit comprising the band pass filter 5, the phase shifter 6, including the amplifier, a connection circuit with the variable frequency oscillator 7 and other appended circuits at a high stability and a fidelity with respect to the phase and the amplitude, thereby causing to vary the oscillation frequency of the variable frequency oscillator 7 at a determined relationship with the frequency change in the input FM signals.

Particularly, supply of the broad base band signals to the variable frequency oscillator 7 in the form of an active circuit involves difficult problems with regard to the stability in view of the circuit structure as well as the correct application of the control signals thereto. If the oscillation of the variable frequency oscillator 7 does not exactly follow the modulated frequency components of high frequency deviation in the FM signals, the frequency deviation in the output signal is made larger as compared with that in the input signal of the frequency converter 2, whereby the FM signal components are eliminated by the band pass filter 3. This results in adverse effect, for instance in that the C/N ratio of the signals inputted to the discriminator 4 is reduced leading to a state below the threshold.

According to the present invention there is provided an FM demodulation circuit wherein FM input signals are subjected to filtering in a band pass filtering means and applied to a frequency discriminator providing at its output FM demodulated signals and wherein a feedback path is provided from the output of the frequency discriminator for a predetermined frequency component of the FM demodulated signals, characterised in that said FM input signals are subject to phase shifting in a variable phase shifting means utilising said predetermined frequency component in the feedback path for compressing the frequency deviation of said predetermined frequency component in the FM input signals. The feedback path to the variable phase shifting means may be continuously operative or may be enabled as a function of the carrier/noise ratio of the FM input signals.

The band pass width of the band pass filtering means may be varied as a function of the carrier/noise ratio of the FM input signals, using a carrier/noise ratio detection signal from either the frequency discriminator or a separate carrier/-noise ratio detector. The varying of the band pass width is preferably such that the band pass width is reduced as the carrier/noise ratio reduces.

The band pass filtering means and the variable phase shifting means may be two separate elements or may be incorporated together in a variable phase shifter having a variable pass band.

The FM input signals may be subjected to preliminary filtering by a further band pass filtering means having a fixed band width near to the Curson band width for demodulation of the FM signals, the band width of the following band pass filter being arranged to be sufficiently broader than that of the further filtering means at a high carrier/noise ratio of the signals that the signals are demodulated with the band width of the further band pass filter.

According to the present invention there is also provided a method of FM demodulation wherein the FM input signals are subjected to band-pass filtering and frequency discrimination to produce FM demodulated output signals, and wherein a predetermined frequency component of the FM demodulated output signals are fed back, characterised in that the FM input signals are subjected to variable phase shifting utilising the fed back frequency component for comprising the frequency deviation of said predetermined frequency component in the FM input signals.

This invention will be better understood from the detailed description given herein before and the accompanying drawings which are given by way of illustration only, and thus are not limitative of this invention and wherein:

Figure 2 is a block diagram for one embodiment of this invention;

Figure 3 is an electric circuit diagram for a specific constitution of the variable phase shifter 9;

Figure 4 is an electric circuit diagram for a specific constitution of a variable band width filter 11;

Figure 5 is a graph showing the characteristic of the embodiment illustrated in Figure 2;

Figure 6 is a block diagram for another embodiment of this invention;

Figure 7 is an electric circuit diagram for a specific constitution of the variable phase shifter 13;

Figure 8 and Figure 9 are graphs respectively showing the characteristic of the variable phase shifter 13;

Figure 10 is an electric circuit diagram for the specific characteristic of the characteristic compensation circuit 14;

Figure 11 is a block diagram for a further embodiment of this invention; and

Figure 12 is a block diagram for a still further embodiment of this invention.

Reference will at first be made to the feature of video signals applied with emphasis prior to the explanation for one embodiment of this invention. Colour video signals comprise luminance signals and colour signals and contain frequency components up to about 4.2 MHz in the case of the NTSC system. Among them, most of the energies of the luminance signals are concentrated to a low frequency region twice as high as the multiple of horizontal scanning frequency (15.75 KHz) and those of the colour component are concentrated near 3.58 MHz. When a preemphasis circuit for instance determined by CCIR.REC 405-1 is applied to this kind of video signals, power weighing is given by about −10 db for the lower frequency component and by about +3 db for the higher frequency component of the signals. Now considering the typical colour bar signals having the highest saturation degree as the video signals, the luminance signal has the greatest amplitude of 77 IRE and the colour carrier component at 3.58 MHz has the frequency of 88 IRE relative to the greatest amplitude 140 IRE of the signals.

Accordingly, if the weighing is carried out to the signals by the preemphasis circuit, the amplitude of the colour sub carrier component is 127 IRE which is nearer to the greatest amplitude 140 IRE of the source signal. Accordingly, it can be regarded that the instantaneous frequency deviation of the FM signals modulated by the video signals applied with the preemphasis is greatest to provide the problem with respect to the C/N change accompanying the narrowing of the band pass width generally by the colour sub carrier component. Figure 2 is a block diagram showing the basic constitution of one embodiment according to this invention.

FM signals are inputted from an input terminal 1, passed through a variable phase shifter 9 and a variable band pass type filter 10 and then supplied to a frequency discriminator 4. The frequency discriminator is composed of a limiter, an amplifier or the like. The detected output from the frequency discriminator 4 is taken out from a detected signal output terminal 8. While on the other hand, a portion of the base band detection output from the frequency discriminator 4 is passed through a base band filter 11 allowing to pass the colour sub carrier component and a phase adjuster 12 and then supplied to the variable phase shifter 9. C/N detection signals from the frequency discriminator 4 are inputted to the variable band pass filter 10 to limit the band width thereof. Figure 2 shows the case where the C/N ratio is detected due to the noise output from the discriminator 4, but an additional C/N detector may be disposed or control signals from a usual automatic gain control circuit (AGC) may be used.

The colour sub carrier control signals are supplied to the variable phase shifter 9 while adjusting the phase and the amplitude thereof in the phase adjuster 12 such that the frequency deviation due to the colour sub carrier modulation component in the FM signals from the input terminal 1 is compressed, that is, so-called reverse modulated state may be attained.

Then, the output of the FM signals from the variable phase shifter 9 is decreased with respect to the frequency deviation as compared with that of the input and the signal frequency band width is narrowed. Accordingly, if the C/N ratio is lower, the noise component is eliminated by the variable band pass filter whose band width is narrowed to improve the threshold characteristic.

Then, the effect for improving the C/N ratio, that is, the threshold improving effect in this system will now be outlined by taking notice only on the colour sub carrier frequency component as described before. The input FM signals in Figure 2 are now represented with respect to the phase as below:

$$Si = A \cdot \sin(\omega t + a \cdot \sin p \cdot t) \qquad (1)$$

The output signal from the variable phase shifter 9 are represented while omitting the fixed phase term as:

$$So = A \cdot \sin(\omega \cdot t + b \cdot \sin p \cdot t) \qquad (2)$$

where $\omega$ is the center angular frequency for the FM signals, p is a modulation angular frequency which corresponds to the colour sub carrier component in this case. The angular frequency deviation $\Delta\Omega$ for the input Si is represented as:

$$\Delta\Omega = a \cdot p \qquad (3)$$

The angular frequency deviation $\Delta\omega$ for the output Si from the variable phase shifter is represented as:

$$\Delta\omega = b \cdot p \qquad (4)$$

where a, b are constants.

Then, assuming the detection sensitivity of the discriminator 4 as K0, the gain of the amplifier in the base band filter 11 as K1 and the phase of the phase adjuster 12 as $\theta$, the control voltage e0 for the variable phase shifter 9 is represented as:

$$e0 = K0 \cdot K1 \cdot \Delta\omega\cos(p \cdot t - \theta) \qquad (5)$$

While on the other hand, assuming the relationship between the phase amount $\Phi$ and the control voltage e0 of the variable phase shifter as:

$$\Phi = K2 \cdot e0 \qquad (6)$$

then

$$\Phi=K \cdot \Delta\omega\cos(p \cdot t-\theta) \qquad (7)$$

$$\kappa=K0 \cdot K1 \cdot K2 \qquad (8)$$

The phase $(\angle So(\theta))$ for the output signal So from the phase shifter is represented as:

$$\angle So(\theta)=a \cdot \sin pt-k \cdot \cos(p \cdot t-\theta) \qquad (9)$$

$$k=K \cdot \Delta\omega \qquad (10)$$

Now assuming:

$$\theta+\frac{\pi}{2}=\theta1 \qquad (11)$$

then

$$\angle So(\theta)=a \cdot \sin p \cdot t+k \cdot \sin(p \cdot t-\theta1)$$
$$=C \cdot \cos(p \cdot t-\varphi) \qquad (12)$$

$$C=\{a^2+k^2+2 \cdot a \cdot k \cdot \cos\theta1\}^{1/2} \qquad (13)$$

$$\varphi=\tan^{-1}\frac{-a-k \cdot \cos\theta1}{k \cdot \sin\theta1} \qquad (14)$$

If

$$\theta=\pi/2 \qquad (\theta1=\pi) \qquad (15)$$

Then, the phase $\angle So(\pi/2)$ in the equation (6) is represented as:

$$\angle So(\pi/2)=(a-k)\sin p \cdot t \qquad (16)$$

Then,

$$b=a-k=a-K\cdot\Delta\omega \qquad (17)$$

Accordingly, the angular frequency deviation of the output So from the variable phase shifter relative to the angular frequency deviation $\Delta\Omega=ap$ for the input Si is represented as:

$$\Delta\omega=\Delta\Omega-K \cdot p\Delta\omega \qquad (18)$$

and

$$\Delta\omega=\frac{\Delta\Omega}{1+K \cdot p} \qquad (19)$$

That is, the angular frequency deviation for the output signal So from the variable phase shifter is compressed to $1/(1+K \cdot p)$ as compared with that for the input signal 1 under such conditions.

Then, the signal threshold characteristic in the discriminator 4 is determined by the band width of the band pass filter accompanying the demodulation. In the case of a usual demodulator having no feedback circuit for the colour sub carrier, if the Curson band width is adapted as usual for the band width Bo of the band pass filter required for demodulation, it is expressed as:

$$Bo=2(p+\Delta\Omega) \qquad (20)$$

While on the other hand, the C/N ratio of the signals inputted to the discriminator 4 is determined by the band width and the noise power N is in proportion to this band width. While on the other hand, in this invention applied with the feedback, since the frequency deviation for the FM signals is compressed, the Curson band width Bf required for the demodulation is represented as below:

$$Bf=2(p+\frac{\Delta\Omega}{1+K \cdot p}) \qquad (21)$$

Accordingly, the degree of improvement $\eta$ for the threshold level is represented as

$$\eta=\frac{Bo}{Bf}=\frac{1+(\Delta\Omega/p)}{1+\{\Delta\Omega/p(1+K \cdot p)\}} \qquad (22)$$

Accordingly, $\eta$ is greater than one by increasing the feedback amount K, whereby the threshold characteristic can be improved.

By the way, upon signal demodulation, it is more advantageous as the demodulated band width is somewhat narrower in view of the threshold characteristic. However, it is better that the demodulation band width is broader in view of the DG, DP characteristics of the demodulated (detected) signals, other waveform distortions or tranquension noises. Particularly, if the C/N ratio is high in the input and the S/N ratio of the modulated signals is high, there is no significant merit of narrowing the demodulation band width at high C/N ratio since the effects of the distortion or tranquension noises are very much remarkable in the demodulated images. As the countermeasure, the variable band pass filter is used to control the band width by using the detected C/N signals in this invention. Specifically, the band width of the variable band pass filter 10 shown in Figure 2 has a broad band characteristic as the C/N ratio goes higher (for instance, at a C/N ratio defined with the Curson band width of the input signal) and it is narrowed as the C/N ratio is lowered.

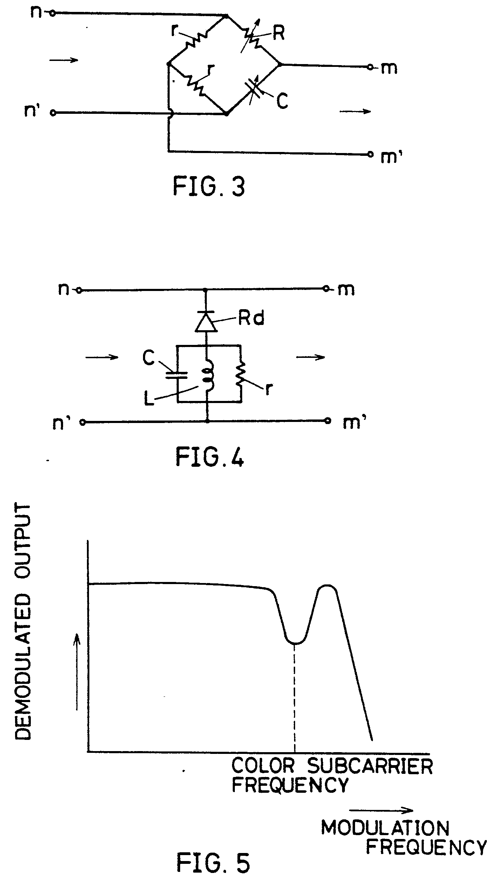

In the system according to this invention, the use of the variable phase shifter and the variable band pass filter has an important role. There are various systems for the variable phase shifter and Figure 3 shows one embodiment. This is the system well known as the bridge method, in which are shown signal input terminals n, n', and output terminals m, m', as well as a resistance, a variable resistance R and a variable capacitance C. In this embodiment, the phase of the output signal is changed by varying the variable resistance or variable capacitance. R or C may be a variable resistor or a variable capacitance diode.

There are also considered various modes for the variable band pass filter and Figure 4 shows one embodiment. In Figure 4, the input resistance is omitted and the pass band width of the variable filter having a single humped transmission characteristic is changed by varying the variable resistance Rd.

By the way, the feature of this system resides in the compression of the frequency deviation for the colour sub carrier modulated component in the FM signals by the variable phase shifter and the elimination of the noises by the variable band pass filter. However, no compression is performed for the frequency deviation in for the FM signals with respect to the signal component other than that near the colour sub carrier signals among the video signals (0—4.2 MHz). Accordingly, the base band signals demodulated by the discriminator show a peculiar characteristic in the frequency characteristic. That is, the frequency characteristic of the base band signals is lowered near the colour sub carrier frequency as illustrated in Figure 5 under the properly adjusted state of this system.

If the phase of the feedback signals to the variable phase shifter is not appropriate, it may sometimes occur that the frequency shift for the output FM signals from the variable phase shifter is increased as compared with that for the input signals, and the demodulated base band signals may show such a frequency characteristic that as the amplitude near the feedback frequency is raised as compared with that for other frequencies different from the case shown in Figure 5. In this case, it also degrades the threshold characteristic.

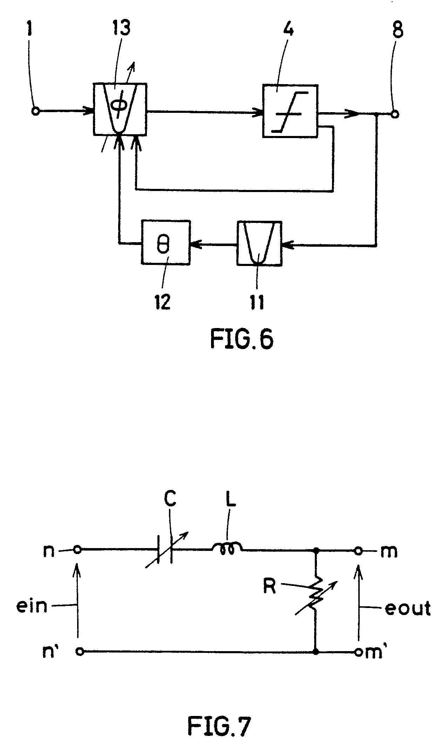

In Figure 6, the system shown in Figure 2 is simplified, in which the variable phase shifter 9 and the variable band pass filter 10 in Figure 2 are not disposed independently but and they are substituted with a variable phase shifter having a function capable of varying the pass band. Reference numeral 13 represents a variable phase shifter having such a function capable of varying the pass band and the portions corresponding to those in Figure 2 have the same reference numerals respectively.

Figure 7 shows a specific basic embodiment of the variable phase shifter 13, in which are shown input terminals n, n' for FM signals, signal output terminals m, m', a variable capacitance C, a variable resistance R and an inductance L. A colour sub carrier frequency component is applied to the variable capacitance by the phase adjuster 12 in Figure 6 and the control signal from the C/N detector is applied to the variable resistor R.

Now assuming the input voltage $e_{in}$ in Figure 7 as:

$$e_{in}=E \cdot \sin\omega t \qquad (23)$$

the output voltage $e_{out}$ is represented as

$$e \cdot out=\frac{E \cdot R}{\sqrt{R^2+(\omega \cdot L-\frac{1}{\omega \cdot C})^2}} \cdot \sin(\omega \cdot t-\Phi) \qquad (24)$$

$$\Phi=\tan^{-1}\frac{(\omega L-\frac{1}{\omega C})}{R} \qquad (25)$$

It is rewritten as:

$$e \cdot out=\frac{E}{\sqrt{1+\tan^2\Phi}} \cdot \sin(\omega \cdot t-\Phi) \qquad (26)$$

That is, the phase of the output voltage is changed by varying the variable capacitance C.

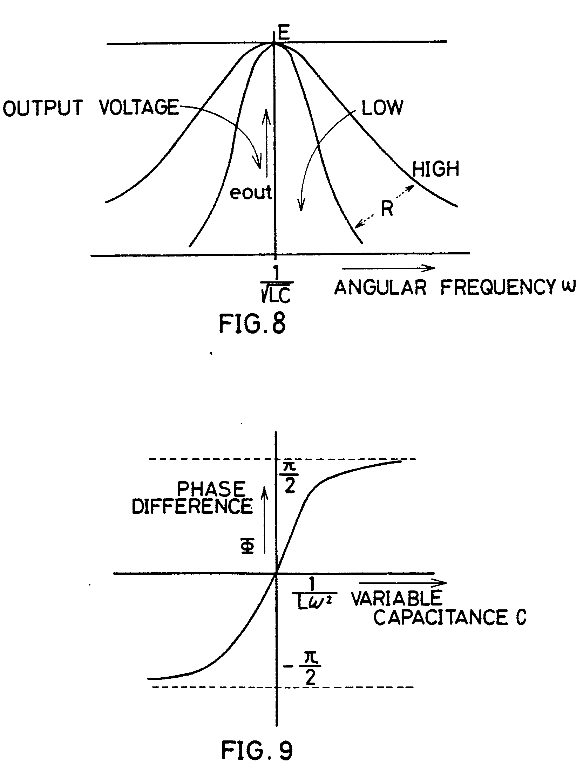

The transmission characteristic of Figure 7 to the angular frequency is defined by the equation (26) as shown in Figure 8. That is, variable band passing characteristics are obtained by varying R relative to fixed values for L and C.

While on the other hand, the phase difference θ between the input/output voltages is changed by varying the variable capacitance C. The relationship between C and the phase amount Φ is shown in Figure 9.

Accordingly, the frequency deviation for the FM signals due to the colour sub carrier component is compressed under the optimum phase control as described above, the noise elimination, that is, the C/N ratio of the signal inputted to the discriminator can be improved by narrowing the band pass characteristic to thereby improve the threshold characteristic.

However, according to this system, it can be seen from the equation (26) that a change in the amplitude (amplitude modulation) is resulted by the change in the phase with respect to the output signals from the variable phase shifter. Accordingly, it is necessary that the limiter used at the subsequent stage to the phase shifter has a sufficient amplitude suppression effect also with respect to the colour sub carrier modulation frequency component. While one embodiment using a serial resonance system is shown, a similar simple structure can also be attained by using a parallel resonance system.

By the way, in this invention, the amplitude of the FM detected signals is decreased at the compressed frequency component in view of its frequency characteristic due to the compression of the specific modulation frequency deviation as shown in Figure 5. Accordingly, if a better characteristic is desired, it is necessary to improve the characteristic by using a compensation circuit for the frequency component.

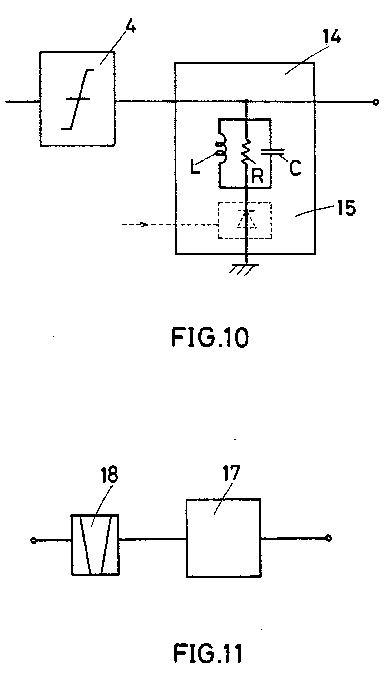

Figure 10 shows one embodiment of such a characteristic compensation circuit 14, in which a parallel resonance system composed of L, C, R is connected to the output of the discriminator shown in Figure 2 or Figure 6 illustrating the embodiment of this invention, to increase the load impedance at a specific frequency thereby increasingly compensate the amplitude characteristic. The resonance frequency of the resonance system is set near the specific frequency.

It is also possible to adjust the degree of addition, elimination or compensation of the compensation circuit shown in Figure 10 by inserting a variable resistor or switching circuit shown by a broken line 15 to the circuit shown in Figure 10. For instance, in the case of controlling continuously or stepwise the absence or presence of the feedback of a specific base band frequency component to the variable phase shifter in this invention by means of the C/N ratio or manual control (block 16 shown in Figure 2 controls the feedback signals by the switch or the variable resistor), FM detected signals with a better frequency characteristic can be obtained by controlling the variable resistor (or switch circuit) 15 by means of the C/N ratio or manual control corresponding to the change in the characteristic of the discriminator output.

In the simple system illustrated in Figure 6, the feedback amount of the colour sub carrier is changed and the detection characteristic for the output from the discriminator is also changed due to the variable change for the band width by the resistance R in Figure 7. In this case it is effective in view of the improvement for the overall characteristics to simultaneously adjust the variable resistance 15 in the Figure 10 by means of the C/N ratio and thereby control the degree of compensation.

Figure 11 shows another embodiment which is further developed from the foregoing embodiment of this invention. The circuit shown by the reference numeral 17 is a FM signal demodulation circuit comprising the constitution shown in Figure 2, Figure 6, Figure 10 or the like, at the preceding stage of which is connected in cascaded a fixed band bass filter 18 having a band width near the Curson band width relative to the input FM signals. In the present system, the demodulation band width is restricted by the filter 18 at the preceding stage in a case where the variable band pass filter (or phase shifter) in Figure 2 or Figure 6 has a sufficiently broad band width.

As described above, according to this invention, a high sensitive FM signal demodulation system simple and easy to realize can be obtained by the use of a variable phase shifter and a variable band pass filter and by performing the feedback of specific modulated signals and the compression of the frequency deviation at a specific C/N ratio, while taking notice on the feature of the colour TV FM modulated signals applied with the emphasis.

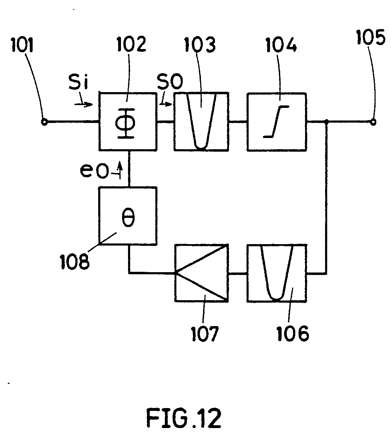

This invention will now be explained by way of a further embodiment shown in Figure 12.

The system shown in the drawing comprises an input terminal 101 for FM signals, a variable phase shifter 102 controlled by external electric signals, a narrow band pass filter 103, a frequency discriminator 104 composed of a limiter, an amplifier or the like, demodulated (detected) output terminal 105 for FM signals, a band pass filter 106 allowing to pass the component near the colour sub carrier (3.58 MHz in the case of NTSC system), an amplifier 107 for the frequency component, a phase adjuster 108 relative to the frequency component or the like. The FM signals, after being inputted into the input terminal 101 and passed through the variable phase shifter 102 and the narrow band pass filter 103, are frequency demodulated in the discriminator 104. A portion of the demodulated base band (video) signals is passed through the band pass filter 106 allowing to pass the specific frequency component (the component near the colour sub carrier), the amplifier 107, etc. and, after being adjusted with the phase in the phase shifter 108, supplied to the variable phase shifter 102. The phase of the variable phase shifter 102 is changed by this control signal, by which the phase of the FM signals inputted from the input terminal 101 is changed. In this state, demodulated (detected) signals of the FM signals are taken out from the demodulated output terminal 105. The constitution of the system shown in Figure 12, except for the feedback circuit for the sub carrier component comprising the band pass filter 106, the amplifier 107 and the phase adjuster 108, as well as the variable phase shifter 102, is quite the same as the conventional frequency demodulator by the discriminator.

The most significant feature of this embodiment is to improve the threshold characteristic by compressing the frequency deviation to thereby narrow the demodulation band width by using the variable phase shifter and the feedback circuit, while taking notice of the colour sub carrier signal component having the greatest frequency deviation and high modulation frequency relative to the demodulation of the video FM signals.

In the present circuit system, the resonance frequency of its own (narrow band pass filter characteristic) can effectively be utilized and, accordingly, the narrow band pass filter 103 as shown in Figure 12 can be saved by providing the circuit with the band pass characteristic narrower than the Curson band width to thereby effectively simplify the circuit structure.

It is to be noted in this embodiment that the frequency deviation of the specific demodulated frequency component in the FM signals is compressed by the variable phase shifter and the C/N ratio is improved by the circuit having the narrow band pass in characteristic to thereby improve the threshold characteristic.

Furthermore, a stable and easy to realize circuit can be provided by using the passive variable phase shifter and the feedback of the specific frequency component.

The circuits shown in Figures 3, 5, 7, 9 and 10 as described for the previous embodiments can also be used in the embodiment shown in Figure 12 but detailed explanations are not repeated here.

As described above, this invention can provide extremely effective means, particularly, for those systems in which a threshold margin is restricted such as in the receiving facility for the broadcasting satellite, as well as the simplicity and the cost reduction are highly required.

**Claims**

1. An FM demodulation circuit wherein FM input signals are subjected to filtering in a band pass filtering means (10) and applied to a frequency discriminator (4) providing at its output FM demodulated signals and wherein a feedback path (11, 12) is provided from the output of the frequency discriminator (4) for a predetermined frequency component of the FM demodulated signals, characterised in that said FM input signals are subjected to phase shifting in a variable phase shifting means (9) utilising said predetermined frequency component in the feedback path for compressing the frequency deviation of said predetermined frequency component in the FM input signals.

2. An FM demodulation circuit according to claim 1, characterised by the provision of means (16) for enabling the feed back path to the variable phase shifting means (9) as a function of the carrier/noise ratio of the FM input signals.

3. An FM demodulation circuit according to claim 1 or claim 2, characterised in that the band pass width of the band pass filtering means is varied as a function of the carrier/noise ratio of the FM input signals.

4. An FM demodulation circuit according to claim 3 characterised in that said band pass width is varied using a carrier/noise ratio detection signal from the frequency discriminator (4).

5. An FM demodulation circuit according to claim 3, characterised in that said band pass width is varied using a carrier/noise ratio detection signal from a separate carrier/noise ratio detector.

6. An FM demodulation circuit according to any of claims 3 to 5 wherein the varying of said band pass width is such that said band pass width is reduced as the carrier/noise ratio reduces.

7. An FM demodulation circuit according to any preceding claim characterised in that said band pass filtering means and said variable phase shifting means are incorporated together in a variable phase shifter (13) having a variable pass band.

8. An FM demodulation circuit according to any preceding claim characterised in that the FM input signals are subjected to preliminary filtering by a further band pass filtering means (18) having a fixed band width near to the Curson band width for demodulation of the FM signals, the band width of the following band pass filter (10) being arranged to be sufficiently broader than that of the further filtering means (18) at a high carrier/-noise ratio of the signals that the signals are demodulated with the band width of the further band pass filter.

9. A method of FM demodulation wherein FM input signals are subjected to band-pass filtering and frequency discrimination to produce FM demodulated output signals, and wherein a predetermined frequency component of the FM demodulated output signals are fed back, characterised in that the FM input signals are subjected to variable phase shifting utilising the fed back frequency component for compressing the frequency deviation of said predetermined frequency component in the FM input signals.

**Patentansprüche**

1. FM-Demodulatorschaltung, bei der FM-Eingangssignale durch einen Bandpass (10) gefiltert und einem Frequenzdiskriminator (4) zugeführt werden, der an seinem Ausgang FMdemodulierte Signale abgibt, und bei dem eine Rückführung (11, 12) vom Ausgang des Frequenzdiskriminators (4) für eine bestimmte Frequenzkomponente des FM-demodulierten Signales vorgesehen ist, dadurch gekennzeichnet, daß die FM-Eingangssignale in einem variablen Phasenschieberglied (9), welches die vorbestimmte Frequenzkomponente in der Rückführung zur Kompensation der Frequenzabweichung der vorbestimmten Frequenzkomponente in dem FM-Eingangssignal verwendet, einer Phasenverschiebung unterworfen werden.

2. FM-Demodulatorschaltung nach Anspruch 1, gekennzeichnet durch Vorrichtungen (16) zur Herstellung einer Rückführung zu dem variablen Phasenschieberglied (9) in Abhängigkeit von dem Trägerrauschen des FM-Eingangssignales.

3. FM-Demodulatorschaltung nach Anspruch 1 oder 2, dadurch gekennzeichnet, daß die Bandpaßbreite des Bandpaßfilters in Abhängigkeit von dem Trägerrauschen des FM-Eingangssignales veränderbar ist.

4. FM-Demodulatorschaltung nach Anspruch 3, dadurch gekennzeichnet, daß die Bandpaßbreite unter Verwendung eines von dem Trägerrauschen abhängigen Detektionssignales des Frequenzdiskriminators (4) veränderbar ist.

5. FM-Demodulatorschaltung nach Anspruch 3, dadurch gekennzeichnet, daß die Bandpaßbreite unter Verwendung eines von dem Trägerrauschen abhängigen Detektionssignals eines getrennten Detektors für Trägerrauschen veränderbar ist.

6. FM-Demodulatorschaltung nach einem der Ansprüche 3 bis 5, dadurch gekennzeichnet, daß die Veränderung der Bandpaßbreite so erfolgt, daß sie mit abnehmendem Trägerrauschen reduziert wird.

7. FM-Demodulatorschaltung nach einem der vorhergehenden Ansprüche, dadurch gekennzeichnet, daß der Bandpaßfilter und das variable Phasenschieberglied zusammen in einem variablen Phasenschieber (13) mit veränderbarer Bandbreite aufgebaut sind.

8. FM-Demodulatorschaltung nach einem der vorhergehenden Ansprüche, dadurch gekennzeichnet, daß die FM-Eingangssignale zur Demodulation einer Vorfilterung durch einen weiteren Bandpaßfilter (18) mit einer festen Bandbreite nahe der Curson-Bandbreite unterworfen sind, und daß die Bandbreite des folgenden Bandpaßfilters (10) so festgelegt ist, daß sie genügend größer ist, als die der weiteren Filter (18) bei einem hohen Trägerrauschen des Signales, so daß die Signale mit der Bandbreite der weiteren Bandpassfilter demoduliert werden.

9. Verfahren zur FM-Demodulation, bei dem die FM-Eingangssignale zur Erzeugung eines FM-demodulierten Ausgangssignales einer Bandpaßfilterung und Frequenzdiskrimination unterworfen werden, und bei dem eine bestimmte Frequenzkomponente des FM-demodulierten Ausgangssignales zurückgeführt wird, dadurch gekennzeichnet, daß die FM-Eingangssignale variablen Phasenverschiebungen unterworfen werden, die zur Unterdrückung einer Frequenzabweichung der bestimmten Frequenzkomponente in dem FM-Eingangssignal in Abhängigkeit von der rückgeführten Frequenzkomponente eingestellt werden kann.

**Revendications**

1. Circuit démodulateur de fréquence, dans lequel des signaux d'entrée à modulation de fréquence sont soumis à un filtrage dans des moyens (10) formant filtre passebande et sont envoyés à un discriminateur de fréquence (4) délivrant, sur sa sortie, des signaux démodulés en fréquence, et dans lequel une boucle de réaction (11, 12) est prévue à partir de la sortie du discriminateur de fréquence (4) pour une composante de fréquence prédéterminée des signaux démodulés en fréquence, caractérisé en ce que lesdits signaux d'entrée à modulation de fréquence sont soumis à un déphasage dans des moyens (9) produisant un déphasage variable et utilisant ladite composante de fréquence prédéterminée dans a boucle de réaction pour comprimer l'écart en fréquence de ladite composante de fréquence prédéterminée dans les signaux d'entrée à modulation de fréquence.

2. Circuit démodulateur de fréquence selon la revendication 1, caractérisé par le fait qu'il est prévu des moyens (16) validant la boucle de réaction aboutissant aux moyens (9) produisant un déphasage variable, en fonction du rapport porteuse/bruit des signaux d'entrée à modulation de fréquence.

3. Circuit démodulateur de fréquence selon la revendication 1 ou 2, caractérisé en ce que la largeur de la bande passante des moyens formant filtre passe-bande est modifiée en fonction du rapport porteuse/bruit des signaux d'entrée à modulation de fréquence.

4. Circuit démodulateur de fréquence selon la revendication 3, caractérisé en ce que ladite largeur de la bande passante est modifiée moyennant l'utilisation d'un signal de détection du rapport porteuse/bruit délivré par le discriminateur de fréquence (4).

5. Circuit démodulateur de fréquence selon la revendication 3, caractérisé en ce que ladite largeur de la bande passante est modifiée moyennant l'utilisation d'un signal de détection du rapport porteuse/bruit délivré par un détecteur séparé du rapport porteuse/bruit.

6. Circuit démodulateur de fréquence selon l'une quelconque des revendications 3 à 5, dans lequel la modification de ladite largeur de la bande passante est telle que cette largeur est réduire lorsque le rapport porteuse/bruit diminue.

7. Circuit démodulateur de fréquence selon l'une quelconque des revendications précédentes, caractérisé en ce que lesdits moyens formant filtre passe-bande et lesdits moyens produisant un déphasage variable sont incorporés ensemble dans un déphaseur (13) produisant un déphasage variable et possédant une bande passante variable.

8. Circuit démodulateur de fréquence selon l'une quelconque des revendications précédentes, caractérisé en ce que les signaux d'entrée à modulation de fréquence sont soumis à un filtrage préliminaire exécuté par des moyens supplémentaires (18) formant filtre passe-bande et possédant une largeur de bande fixe proche de la largeur de bande de Curson pour la démodulation des signaux à modulation de fréquence, la largeur de bande du filtre passe-bande aval (10) étant agencée de manière à être suffisamment plus large que celle des moyens supplémentaires de filtrage (18) pour un rapport porteuse/bruit élevé des signaux pour que les signaux soient démodulés avec la largeur de bande du filtre passe-bande supplémentaire.

9. Procédé de démodulation de fréquence, selon lequel les signaux d'entrée à modulation de fréquence sont soumis à un filtrage passe-bande et à une discrimination de fréquence en vue de l'obtention de signaux de sortie démodulés en fréquence, et selon lequel une composante de fréquence prédéterminée des signaux de sortie démodulés en fréquence est soumise à une réaction, caractérisé en ce que les signaux d'entrée à modulation de fréquence sont soumis à un déphasage variable moyennant l'utilisation de la composante de fréquence envoyée par réaction pour réaliser la compression de l'écart en fréquence de ladite composante de fréquence prédéterminée dans les signaux d'entrée à modulation de fréquence.

FIG.1

FIG.2

0 135 301

FIG. 3

FIG.4

FIG. 5

2

FIG.6

FIG.7

3

OUTPUT VOLTAGE

LOW

HIGH

eout

R

E

$\dfrac{1}{\sqrt{LC}}$     ANGULAR FREQUENCY ω

FIG.8

PHASE DIFFERENCE

$\dfrac{\pi}{2}$

Φ

$\dfrac{1}{L\omega^2}$  VARIABLE CAPACITANCE C

$-\dfrac{\pi}{2}$

FIG. 9

4

FIG.10

FIG.11

FIG.12